# EUROPEAN PATENT APPLICATION

(11) **EP 4 745 614 A1**
(43) Date of publication of application: **20.05.2026**
(21) Application number: 24306934.1
(22) Date of filing: 19.11.2024
(51) Int. Cl.: G01S 7/03, G01S 7/40, G01S 13/931

(54) **FAILURE DETECTION SYSTEM AND METHOD FOR A RADAR SYSTEM**

(71) Applicant: NXP B.V., 5656 AG Eindhoven (NL)
(72) Inventor: SAADI, Ahmed Abdelhalim, 31023 Toulouse (FR); JANG, Jae Sik, 31023 Toulouse (FR); PAVAO MOREIRA, Cristian, 31023 Toulouse (FR)
(74) Representative: Hardingham, Christopher Mark

(57) **Abstract**

The present disclosure relates to a system, such as a radar system, and related method, where the system includes a transmitter module having a power combiner, interconnection structures coupled to the power combiner, and detection circuitry coupled to the power combiner. The detection circuitry may be configured to inject at least one test current onto at least one electrical path that includes the power combiner and at least one of the interconnection structures, compare a first voltage at the at least one electrical path to a reference voltage, and provide, in response to the first voltage exceeding the reference voltage, a failure indication to safety monitoring circuitry.

## Description

### TECHNICAL FIELD

Embodiments of the subject matter described herein relate generally to systems that perform wireless signal transmission, such as automotive radar systems, including circuitry and processes for detecting failure in physical connection points, such as solder balls or pillars, in such systems.

### BACKGROUND

Automotive radar solutions for advanced driver assistance systems (ADAS) are currently being deployed on a large scale, and are typically implemented as long-range radar (LRR) applications or short-range radar (SRR) applications. Both of these applications typically use frequency modulated continuous wave (FMCW) modulation techniques in order to be able to identify objects in the vicinity of the radar system, such as a vehicle or a pedestrian. Such radar systems typically utilize millimeter wave (mmWave) frequencies for transmission and reception or radar signals.

Automotive radar systems typically employ safety mechanisms to comply with established functional safety requirements. Such safety mechanisms may cause the radar system to transition into a fail-safe state in response to a detected failure within the radar system, for example. Potential sources of such failure include cracks or breaks in electrically conductive solder balls or pillars that provide electrical connections between different parts of the radar system, where such cracks or breaks may compromise the integrity or reliability of the radar system.

### BRIEF DESCRIPTION OF DRAWINGS

A more complete understanding of the subject matter may be derived by referring to the detailed description and claims when considered in conjunction with the following figures, wherein like reference numbers refer to similar elements throughout the figures. Elements in the figures are illustrated for simplicity and clarity and have not necessarily been drawn to scale. The figures along with the detailed description are incorporated and form part of the specification and serve to further illustrate examples, embodiments and the like, and explain various principles and advantages, in accordance with the present disclosure, wherein:
FIG. 1 shows a radar system that may be configured to perform failure testing, in accordance with various embodiments;
FIG. 2 shows an illustrative process flow for a method of operating a radar system, such as the radar system of FIG. 1, including BIST processes that may include failure detection, in accordance with various embodiments;
FIG. 3 shows a diagram illustrating break detection circuitry coupled to pillars and a solder ball via a power combiner, each of which may be collectively included in a radar system such as the radar system of FIG. 1, in accordance with various embodiments;
FIG. 4 shows an illustrative diagram showing break detection circuitry coupled to pillars and a solder ball via a power combiner and showing a peak detector coupled to the pillars and the solder ball, each of which may be collectively included in a radar system such as the radar system of FIG. 1, in accordance with various embodiments;
FIG. 5 shows an illustrative circuit diagram showing break detection circuitry, which may be used to implement the break detection circuitry of FIG. 3 or the break detection circuitry of FIG. 4, in accordance with various embodiments;
FIG. 6 shows an illustrative process flow for a method of failure detection using break detection circuitry, such as the break detection circuitry of FIG. 3, in accordance with various embodiments; and
FIG. 7 shows an illustrative process flow for a method of failure detection using break detection circuitry and a peak detector, such as the break detection circuitry and peak detector of FIG. 4, in accordance with various embodiments.

### DETAILED DESCRIPTION

The following detailed description is merely illustrative in nature and is not intended to limit the embodiments described herein and uses of such embodiments. Furthermore, there is no intention to be bound by any expressed or implied theory presented in the preceding technical field, background, or the following detailed description.

For simplicity and clarity of illustration, the figures illustrate the general manner of construction. Descriptions and details of well-known features and techniques may be omitted from the following detailed description to avoid unnecessarily obscuring the present disclosure. For example, the dimensions of some of the elements or regions in the figures may be exaggerated relative to other elements or regions to help improve understanding of embodiments described herein.

The terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments described herein are, for example, capable of operation in sequences other than those illustrated or otherwise described herein. Furthermore, the terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. As used herein the terms "approximate," "approximately," "substantial" and "substantially" mean sufficient to accomplish the stated purpose in a practical manner and that minor imperfections, if any, are not significant for the stated purpose.

Along these lines, when used with references to measurable quantities including, but not limited to, dimensions, these terms mean that the quantities are equal to the values stated subject to accepted tolerances of any methods or apparatus chosen to fabricate the described structures or measure the quantities or dimensions described. Directional references such as "top," "bottom," "left," "right," "above," "below," and so forth, unless otherwise stated, are not intended to require any preferred orientation and are made with reference to the orientation of the corresponding figure or figures for purposes of illustration. As used herein, the words "exemplary" and "example" mean "serving as an example, instance, or illustration." Any implementation described herein as exemplary or an example is not necessarily to be construed as preferred or advantageous over other implementations. In addition, certain terms may also be used herein for reference only, and thus are not intended to be limiting.

Herein, elements or nodes or features are sometimes referred to as being "connected" or "coupled" together. As used herein, unless expressly stated otherwise, "connected" means that one element is directly joined to (or directly communicates with) another element in an electrical or non-electrical manner, and not necessarily mechanically. Likewise, unless expressly stated otherwise, "coupled" means that one element is directly or indirectly joined to (or directly or indirectly communicates with) another element in an electrical or non-electrical manner, and not necessarily mechanically. Thus, although the schematic illustrations shown in the figures depict exemplary arrangements of elements, additional intervening elements, devices, features, or components may be present in one or more embodiments of the depicted subject matter.

Various embodiments described herein relate to radar systems, such as automotive radar systems, configured to perform one or more failure detection processes (e.g., one or more steps of which may be performed as part of a built-in self-test (BIST) process), where the radar system is configured to detect breaks in one or more electrical paths of the radar system (e.g., which may correspond to breaks in one or more pillars or solder balls of the radar system) by injecting current along such electrical paths while measuring the DC voltage, peak RF voltage, or both at or along such paths. In response to determining that a voltage or power measurement obtained during the failure detection process exceeds a corresponding threshold, the radar system may be configured to enter a fail-safe state (e.g., which may be triggered via assertion of a flag by break detection circuitry of the radar system, in one or more embodiments). In the fail-safe state, regular functionality of the radar system may be disabled. In one or more embodiments, in the fail-safe state, the radar system may be configured to cause a display system (e.g., part of an infotainment system or dashboard display) in a vehicle that includes the radar system to show one or more messages or symbols indicating that the radar system is disabled or indicating that maintenance is required, as non-limiting examples.

Conventional radar systems typically include various circuit boards, integrated circuit die, integrated circuit packages and the like, where connections between such elements are achieved through electrically conductive (e.g., metal) interconnection structures, which may include pillars, solder balls, or the like. Because such interconnection structures are common points of failure in such radar system, it is generally desirable to monitor the state of the electrical paths passing through the pillars and solder balls. However, monitoring electrical paths that carry high frequency (e.g., radio-frequency (RF)) signals during normal operation of such radar systems using conventional approaches can adversely affect signal power (e.g., where one or more such conventional approaches requiring looping of the RF signal from one pathway to another through the utilization of an external balun). For example, the transmit (TX) output power of a transmitter of the radar system may be undesirably reduced when using conventional means to monitor interconnection structures included in electrical paths at or near the output of the transmitter.

Embodiments herein address these challenges by injecting one or more test currents into electrical paths that pass through the monitored interconnection structures via a power combiner of a transmitter module that includes or that is electrically coupled to the monitored interconnection structures. Herein, the term "current" refers to an electrical current unless otherwise indicated. In one or more embodiments, break detection circuitry is configured to compare respective voltages of the electrical paths to reference voltages while the test currents are injected. In response to determining that the voltage at one such electrical path exceeds the corresponding reference voltage, the break detection circuitry may indicate that failure of at least one of the interconnection structures (and, therefore, failure of the radar system) has occurred. For example, the break detection circuitry may provide such a failure indication by asserting a binary flag (e.g., in a computer-readable memory device coupled to the break detection circuitry) or by sending a binary or non-binary signal to safety monitoring circuitry of the radar system, as non-limiting examples.

In one or more embodiments, the outputs of the power combiner may be coupled to a transmit antenna of the radar system via interconnection structures (e.g., electrically conductive pillars, solder balls, and the like). In one or more embodiments, the interconnection structures may include a solder ball connected to the TX antenna and may include first and second electrically conductive (e.g., metal) pillars coupled between the solder ball and the outputs of the power combiner. A quarter-wave stub may be disposed between the solder ball and the TX antenna. The quarter-wave stub may provide a path to ground for direct-current (DC) signals, such as the injected test currents. In one or more embodiments, the power combiner includes first and second inductive loops. The first inductive loop may be connected between the break detection circuitry and the interconnection structures (e.g., the first and second conductive pillars). The second inductive loop may be electromagnetically (e.g., inductively) coupled to the first loop and may be connected to outputs of power amplifiers of the transmitter module. In one or more embodiments, during RF signal transmission, the second inductive loop receives RF signals from the power amplifiers and electromagnetically couples the RF signals to the first inductive loop, and the first inductive loop then passes the RF signals to the antenna via one or more interconnection structures.

In one or more embodiments, the break detection circuitry may include first and second outputs that are coupled to first and second portions of the first inductive loop of the power combiner. In one or more such embodiments, the first portion of the first inductive loop may be physically separated from the second portion of the first inductive loop by gaps or breaks disposed at two opposite sides of the first inductive loop. The first portion of the first inductive loop may be coupled between and may provide an electrical connection between the first output of the break detection circuitry and a first output of the power combiner. The second portion of the first inductive loop may be coupled between and may provide an electrical connection between the second output of the break detection circuitry and the second output of the power combiner. In such embodiments, during a failure detection process, the break detection circuitry may inject two separate test currents into the power combiner. For example, the break detection circuitry may be configured to inject a first test current into the first portion of the first inductive loop and to inject a second test current into the second portion of the second inductive loop. The break detection circuitry may inject the first and second test currents simultaneously. The break detection circuitry may measure or otherwise monitor the voltages at the first and second outputs of the break detection circuitry to determine whether failure (e.g., breakage of an interconnection structure) has occurred. The break detection circuitry may be configured to measure the voltages simultaneously.

In one or more other embodiments, the break detection circuitry may include first and second outputs that are coupled to a single node of the first inductive loop of the power combiner. In one or more such embodiments, the first inductive loop may include a single break or gap that separates the first and second outputs of the first inductive loop. In such embodiments, during a failure detection process, the break detection circuitry may inject test currents into the node of the first inductive loop of the power combiner. The break detection circuitry may measure or otherwise monitor the voltages at the first and second outputs of the break detection circuitry to determine whether failure (e.g., breakage of an interconnection structure) has occurred. The outputs of the power combiner may correspond to two separate electrical paths. In one or more such embodiments, a peak detector may be coupled to the outputs of the power combiner, and may measure the peak RF voltage at the two electrical paths during the transmission of RF signals by the radar system. In response to determining that the measured peak RF voltage of a given one of the electrical paths exceeds a corresponding predefined threshold, the peak RF voltage detector may indicate that failure one of the interconnection structures has occurred (e.g., by asserting a flag or sending a failure indication signal to safety monitoring circuitry of the radar system).

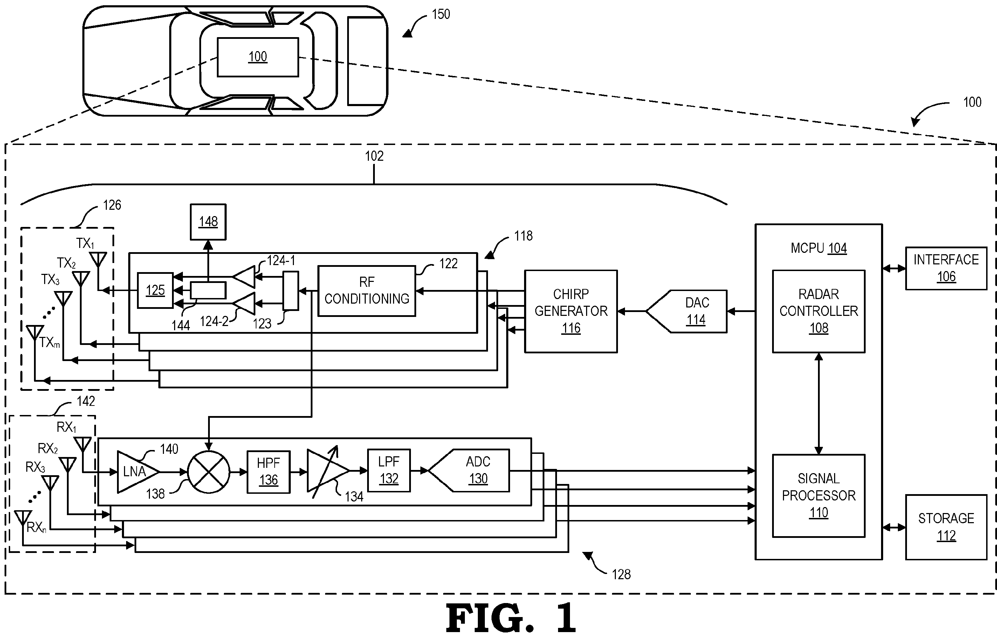

FIG. 1 shows an illustrative diagram of a radar system 100 which includes a radar device 102 (sometimes referred to herein as "radar communication circuitry 102" or "radar front-end circuitry 102") that is connected to a radar microcontroller and processing unit (MCPU) 104. The radar system 100 may include break detection circuitry 144 that is configured to perform a failure detection process by which breaks in interconnection structures (e.g., conductive pillars, solder balls, or other suitable interconnection structures) electrically connecting transmitter modules of the radar system 100 to corresponding transmit antennas of the radar system 100 may be detected. Embodiments of such failure detection processes are described further below.

In one or more embodiments, the radar system 100 may be a Multiple-Input Multiple-Output (MIMO) radar system, such as a Linear Frequency Modulation (LFM) MIMO radar system (e.g., an LFM automotive MIMO radar system). In one or more embodiments, the radar device 102 may include radar front-end hardware. In one or more embodiments, the radar device 102 may be embodied as a line-replaceable unit (LRU) or modular component that is designed to be replaced quickly at an operating location. Similarly, the radar MCPU 104 may be embodied as a line-replaceable unit (LRU) or modular component. Although a single or mono-static radar devices are shown, it will be appreciated that additional distributed radar devices may be used to form a distributed or multi-static radar. In addition, the depicted radar system 100 may be implemented in integrated circuit form with the radar device 102 and the radar MCPU 104 formed on separate integrated circuits (chips) or on a single chip, depending on the application. In accordance with various embodiments, the radar system 100 may be implemented as part of an automotive system in conjunction with an Advanced Driver Assistance System (ADAS) of a vehicle, such as a vehicle 150. It should be understood that components of the radar system 100 may be distributed at various locations on or within the vehicle 150 (e.g., with antennas located at one or more front, rear, or side panels of the vehicle 150, at front or rear bumpers of the vehicle 150, or at other suitable locations on the vehicle 150, or at a combination of such locations; with processing circuitry, transmitter modules, and receiver modules being disposed at one or more locations inside the vehicle 150).

The radar device 102 includes one or more transmitting antenna elements 126 (sometimes referred to herein as "transmit antennas 126") and receiving antenna elements 142 (sometimes referred to herein as "receive antennas 142") connected, respectively, to one or more radio-frequency (RF) transmitter (TX) modules 118 and receiver (RX) modules 128. Each transmit antenna 126 and TX module may be associated with a respective transmit channel of a group of transmit channels designated herein as TX₁, TX₂, TX₃, ... TXₘ, where "m" is the total number of transmit channels. Each receive antenna 142 and RX module 128 may be associated with a respective receive channel of a group of receive channels designated herein as RX₁, RX₂, RX₃, ... RXₙ, where "n" is the number of receive (RX) channels. As a non-limiting example, a radar device (e.g., the radar device 102) can include individual antenna elements (e.g., transmitting antenna elements 126) connected, respectively, to four transmitter modules (e.g., the transmitter modules 118) and sixteen receiver modules (e.g., the receiver modules 128). These quantities of transmitter and receiver antenna elements and modules are intended to be illustrative and not limiting, with other quantities of these elements being possible in one or more other embodiments, such as four transmitter modules 118 and six receiver modules 128, or a single transmitter module 118 and/or a single receiver module 128.

The radar device 102 includes a chirp generator 116, which is configured to supply chirp input signals to the transmitter modules 118. To this end, the chirp generator 116 is configured to receive input program and control signals, including, as non-limiting examples, a reference local oscillator (LO) signal, a chirp start trigger signal, and program control signals, from the MCPU 104 via a digital-to-analog converter (DAC) 114. The chirp generator 116 is configured to generate chirp signals and send the chirp signals to the transmitter modules 118 for transmission via the transmitting antenna elements 126. In one or more embodiments, each transmitter module 118 includes an RF conditioning module 122 that may be configured to filter the chirp signals prior to transmission. In one or more embodiments, the RF conditioning module 122 may include one or more frequency multipliers configured to increase the frequency of chirp signals output by the chirp generator 116. Each transmitter module 118 includes a splitter 123, power amplifiers 124, a power combiner 125, and break detection circuitry 144. The power amplifiers 124 are configured to amplify the filtered chirp signals before they are provided to and transmitted via one or more corresponding transmitting antenna elements 126. Herein, a transmitted chirp signal is sometimes referred to as a "transmit signal" or a "transmitted radar signal".

One or more of the radar signals transmitted by the transmitter modules 118 and transmit antennas 126 may be reflected by an object in an environment of the radar device 102, and at least part of the reflected radar signal(s), sometimes referred to herein as "return signals," "reflections," or "echoes" may be included in an RF signal that is received by the receiving antenna elements 142 at the radar device 102. In one or more embodiments, a reflected radar signal received via one of the receiving antenna elements 142 and a corresponding one of the receiver modules 128 corresponds to a reflection of a chirp signal transmitted via one of the transmit antennas 126 and a corresponding transmitter module 118. The received reflection may include interference components attributable to one or more interference signals in the environment of the radar system 100 (e.g., with such interference signals being removed during subsequent processing, which may be performed by the signal processor 110). At each receiver module 128, the received RF signal (e.g., which may include a reflected radar signal) is amplified by a low noise amplifier (LNA) 140 and then provided to a mixer 138 where the received RF signal is mixed with the transmitted radar signal output by the RF conditioning module 122. The resulting intermediate frequency (IF) signal is provided to a high-pass filter (HPF) 136. The resulting filtered signal is provided to a variable gain amplifier 134, which amplifies the filtered signal before providing the resultant amplified filtered signal to a low pass filter (LPF) 132. The LPF 132 filters the amplified filtered signal to produce a re-filtered signal. This re-filtered signal is provided to an analog/digital converter (ADC) 130 and is output by the receiver module 128 (e.g., output to the signal processor 110 of the MCPU 104) as a digital signal. In one or more embodiments, by processing received RF signals in this way, the receiver modules 128 may compress the echo of various delays into multiple sinusoidal tones whose frequencies correspond to the round-trip delay of the echo.

In the radar system 100, the radar MCPU 104 may be connected to and configured to supply input control signals to the radar device 102 and to receive therefrom digital output signals generated by the receiver modules 128. In one or more embodiments, the radar MCPU 104 includes a radar controller 108 and a signal processor 110 (sometimes referred to herein as "signal processing circuitry 110"), either or both of which may be embodied as a microcontroller unit or other processing unit. The MCPU 104, the radar controller 108, and the signal processor 110 each include or are implemented by computer processing circuitry, in accordance with various embodiments. The radar controller 108 can receive data from the radar device 102 (e.g., from the receiver modules 128) and can control radar parameters of the radar device 102, such as frequency band, length of each radar frame, and the like via the DAC 114. For example, the DAC 114 may be used to adjust the radar chirp signals output from the chirp generator 116 included in the radar device 102. The signal processor 110 may be configured and arranged for signal processing tasks such as, but not limited to, object identification, interference mitigation, computation of the distance or range to a detected object, computation of the radial velocity of a detected object, and computation of the AoA of signals reflected by a detected object, and the like. Herein, the term "AoA" or "Angle-of-Arrival" refers to the angle of a reflected signal (e.g., a reflected radar signal) incident on an antenna array. The signal processor 110 can provide calculated values associated with such computations to a storage 112 and/or to other systems via an interface 106.

The interface 106 can enable the MCPU 104 to communicate with other systems over local and wide area networks, the internet, automotive communication buses, and/or other kinds of wired or wireless communication systems, as non-limiting examples. In one or more embodiments, the MCPU 104 can provide the calculated values over the interface 106 to other systems, such as a radar-camera-lidar fusion system; an automated driving assistance system including parking, braking, or lane-change assistance features; or the like. The storage 112 can be used to store instructions for the MCPU 104, received data from the radar device 102, calculated values from the signal processor 110, and the like. Storage 112 can be any suitable storage medium, such as a volatile or non-volatile computer-readable memory.

To control the transmitter modules 118, the radar controller 108 may, for example, be configured to generate transmitter input signals, such as program, control trigger, reference LO signal(s), calibration signals, frequency spectrum shaping signals (such as ramp generation in the case of Frequency-Modulated Continuous Wave (FMCW) radar). The radar controller 108 may, for example, be configured to receive data signals, sensor signals, and/or register programming or state machine signals for RF (radio frequency) circuit enablement sequences.

At each receiver module 128, digital output signals are generated (e.g., as ADC samples generated by the ADCs 130) from return signals (i.e., reflected radar signals received via the receiver modules 128) for digital processing by the signal processor 110 to construct and accumulate multiple-input multiple-output (MIMO) array vector outputs forming a MIMO aperture for use in computing plots or maps for AoA estimation and object tracks. For example, upon receiving raw ADC samples from an ADC 130 of a receiver module 128, the signal processor 110 may perform one or more interference suppression processes on the digital output signals before processing the resultant interference-suppressed ADC samples using one or more fast Fourier transform (FFT) modules or Discrete Fourier Transform (DFT) modules, such as a fast-time (range) FFT module and a slow-time (Doppler) FFT module. In one or more embodiments, processing of the interference-suppressed ADC samples by the fast-time FFT module generates a range chirp antenna cube (RCAC) and subsequent processing of the RCAC by the slow-time (Doppler) FFT module generates a range-Doppler antenna cube (RDAC) (e.g., including range-Doppler response maps for each receive antenna 142). The signal processor 110 may then perform Constant False Alarm Rate (CFAR) detection on the range-Doppler antenna cube to detect peaks in the RDAC. The signal processor 110 may further process the RDAC based on the detected peaks to construct a MIMO array vector which the signal processor 110 then processes to perform AoA estimation and object tracking. The MCPU 104 may then output the resulting object tracks (e.g., via the interface 106) to other automotive computing or user interfacing devices for further processing or display.

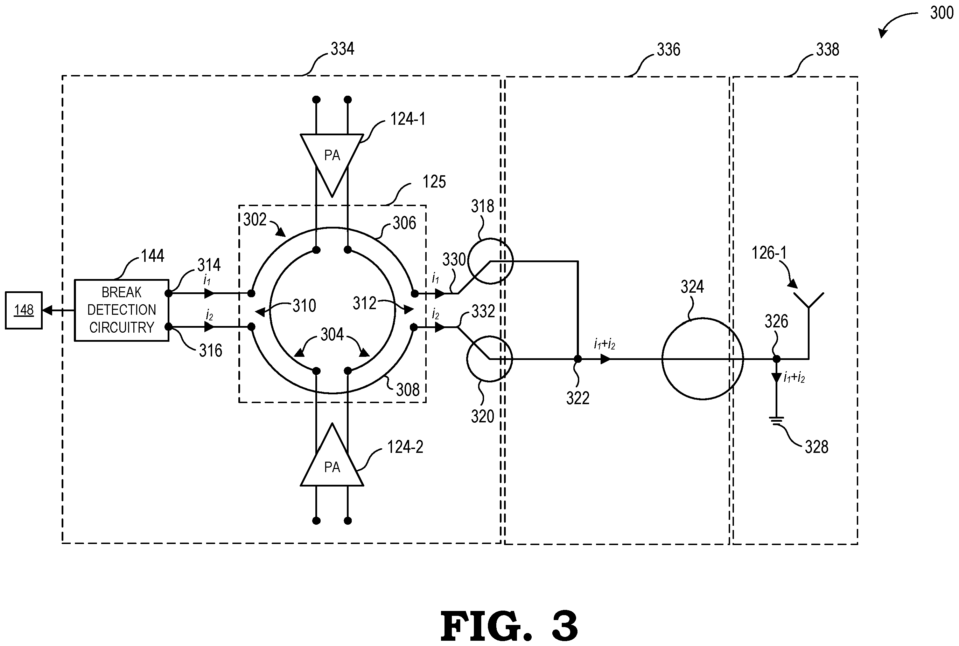

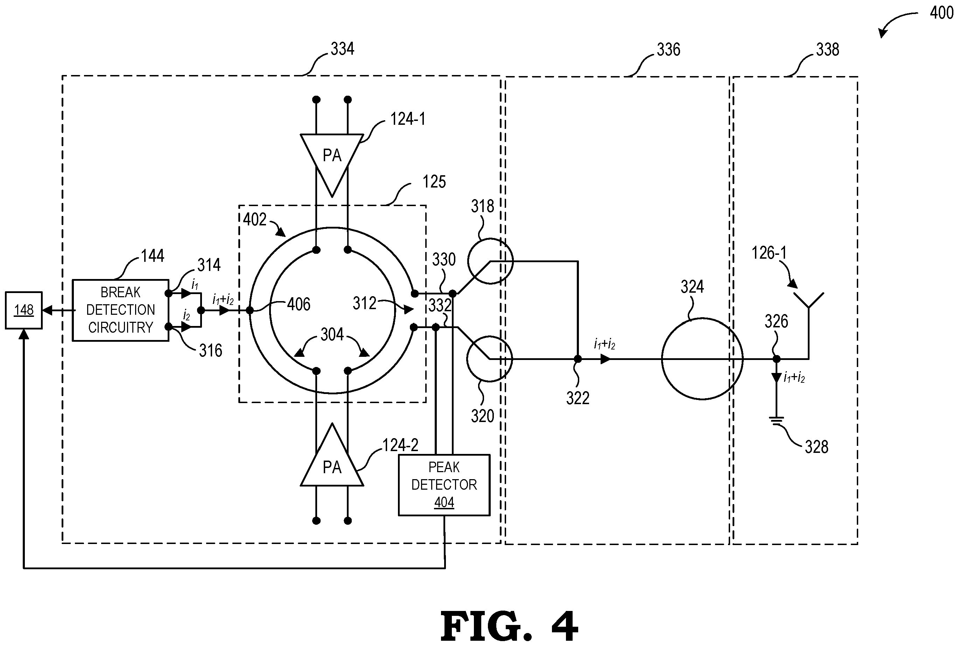

The transmitter modules 118 may each include break detection circuitry 144 that is configured to determine whether a break (e.g., an interrupted electrical connection) has occurred along one or more electrical paths between the power amplifiers 124 of the transmitter module 118 and a corresponding transmit antenna 126. In one or more embodiments, the break detection circuitry 144 may be configured to perform a failure detection process during which the break detection circuitry may inject one or more test currents into the power combiner 125 of the corresponding transmitter module 118. When no breaks are present in the electrical path(s) between the power combiner 125 and the corresponding transmit antenna 126, the injected test current(s) may be passed to a ground or reference node (e.g., a quarter-wave stub dimensioned and arranged to act as a direct-current (DC) ground) that is connected to an electrical path leading to the corresponding transmit antenna 126. The break detection circuitry 144, while injecting the test current(s), may measure or otherwise monitor voltages at one or more electrical paths disposed between the power combiner 125 and the corresponding transmit antenna 126. The monitored electrical paths may include one or more interconnection structures (not shown), such as solder balls, electrically conductive pillars, or other suitable interconnection structures (e.g., the conductive pillars 318, 320 of FIGS. 3 and 4 or the solder ball 324 of FIGS. 3 and 4). By monitoring the voltages along such electrical paths, the break detection circuitry 144 may determine when a break in the electrical paths (typically corresponding to a break in one or more of the interconnection structures) has occurred. In response to such a determination, the break detection circuitry 144 may send a failure indication to functional safety monitoring circuitry 148. In one or more embodiments, each transmitter module 118 may additionally include a peak detector (not shown; e.g., the peak detector 404 of FIG. 4), which, may be configured to monitor the peak RF voltage (i.e., the peak voltage of an RF signal) at the electrical path(s) between the power combiner 125 and the corresponding transmit antenna 126 while RF signals are transmitted by the radar system 100. In one or more such embodiments, the peak detector may provide a failure indication to the functional safety monitoring circuitry 148 based on peak RF voltage measurements taken from one or more electrical paths between the power combiner 125 and a corresponding transmit antenna 126.

In response to receiving a failure indication from the break detection circuitry 144 (or from a peak detector, in one or more embodiments), the functional safety monitoring circuitry 148 may take one or more suitable actions, such as disabling the radar system 100, causing a message indicating failure of the radar system 100 to be displayed at the vehicle 150 (e.g., at a dashboard display or infotainment system of the vehicle 150), or a combination of such actions, as non-limiting examples. Embodiments of methods and circuitry that may be used to perform such failure detection processes (e.g., by a radar system, such as the radar system 100) are described in more detail below in connection with FIGS. 3-7.

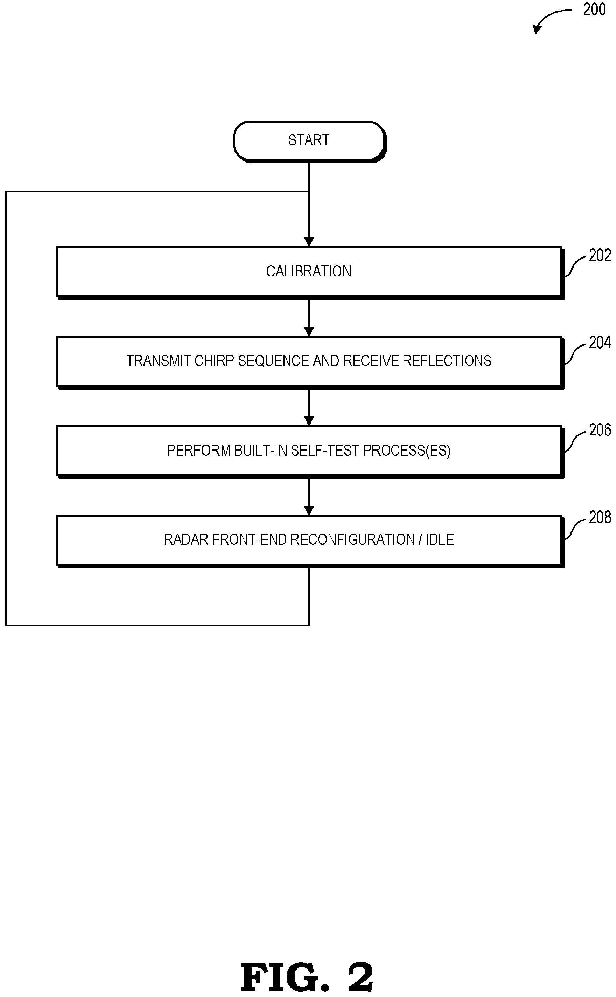

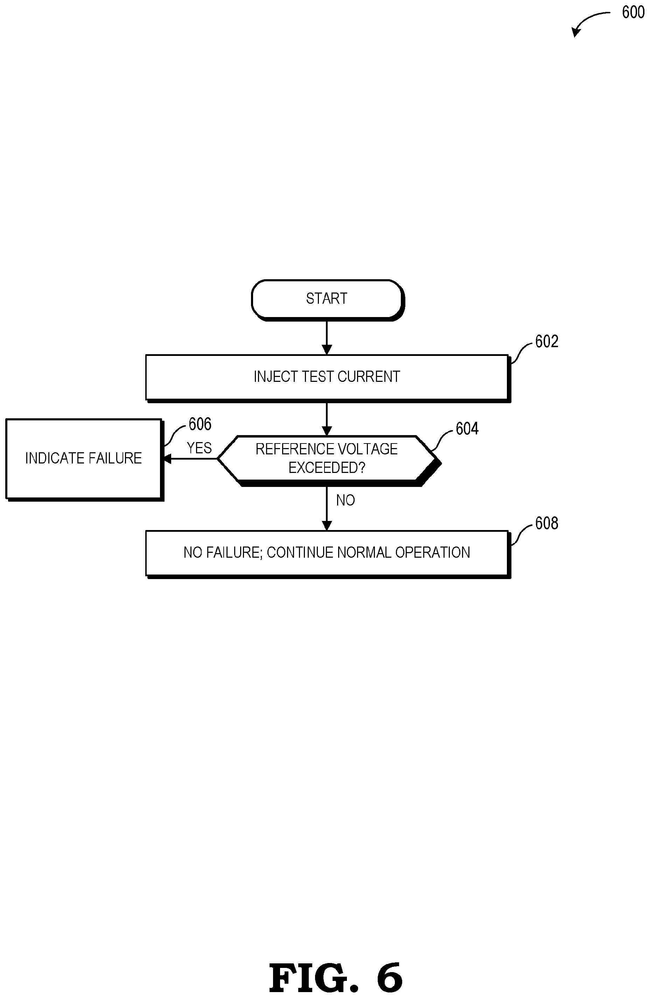

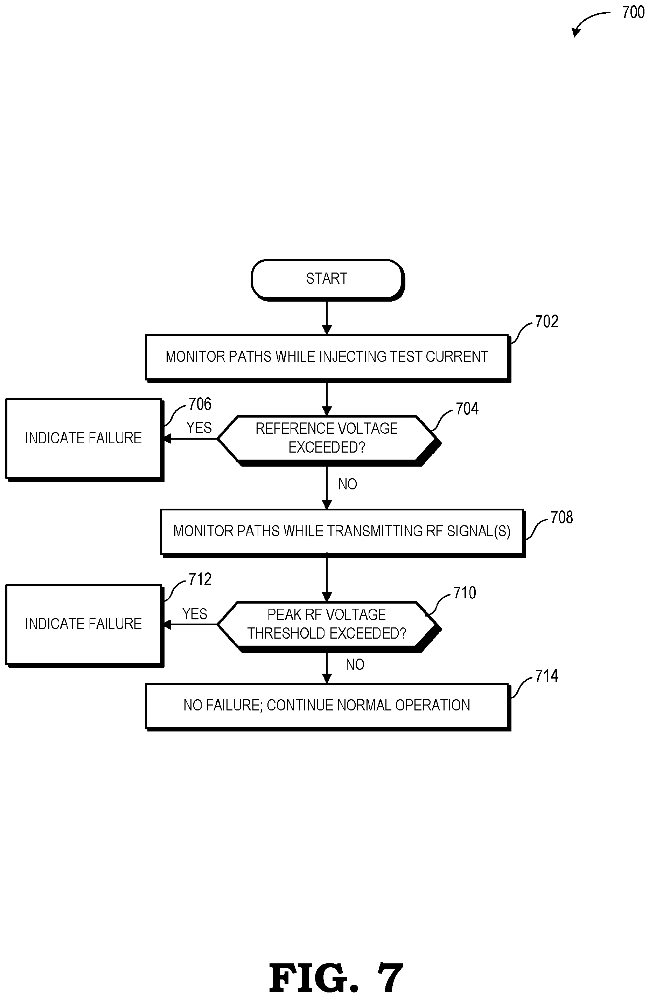

FIG. 2 shows an illustrative process flow for a method 200 illustrating a radar front-end (RFE) radar cycle that includes the performance of one or more built-in self-test (BIST) processes, which may include one or more failure detection processes (e.g., an embodiment of the method 600 of FIG. 6 or an embodiment of the method 700 of FIG. 7, as non-limiting examples), such as those used to detect interconnection structures breakage. The method 200 may be performed using RFE circuitry of a radar system (e.g., the radar front-end circuitry 102 of the radar system 100 of FIG. 1). The method 200 is described with reference to elements of the radar system 100 of FIG. 1. However, it should be understood that this is illustrative and not limiting, at least in that other suitable radar systems may be used to carry out the method 200 in one or more other embodiments.

At block 202, the radar front-end circuitry 102 performs a calibration process (e.g., which may include phase calibration, frequency calibration, gain calibration or other suitable calibration processes).

At block 204, the radar front-end circuitry 102 transmits a chirp sequence (e.g., a sequence of radar signals) via the transmitter modules 118 and the transmit antennas 126 and receives reflections of the transmitted chirps via the receiver modules 128 and the receive antennas 142. The reflections of the transmitted chirps may be reflected by one or more objects in an environment of the radar system 100. Such reflections are sometimes referred to as "reflected radar signals" herein.

At block 206, after the sequence of chirps has been transmitted by the transmitter modules 118 and the transmit antennas 126 and corresponding reflections have been received by the receiver modules 128 and the receive antennas 142, the radar front-end circuitry 102 performs one or more BIST processes. In one or more embodiments, one or more steps of a failure detection may be performed the break detection circuitry 144 as part of such a BIST process.

In one or more embodiments, such a failure detection process may be carried out by a given transmitter module 118 of the radar front-end circuitry 102. For example, the break detection circuitry 144 of the given transmitter module 118 may be configured to inject one or more test currents into the power combiner 125, attempting to pass the test currents through one or more interconnection structures to a DC ground or reference node disposed at or near an input to a corresponding transmit antenna 126. For example, the break detection circuitry 144 may inject first and second test currents into the power combiner 125 simultaneously. The break detection circuitry 144 may compare one or more reference voltages to one or more voltages at one or more electrical paths at which each test current is injected, thereby monitoring the electrical path voltage(s). In response to determining that the voltage at a given monitored electrical path exceeds the reference voltage, the break detection circuitry 144 may provide an indication that the system has failed. To provide such an indication, the break detection circuitry 144 may assert a binary flag or send a binary or non-binary message to functional safety monitoring circuitry 148 of the radar system 100, as non-limiting examples. In response to the failure indication, the functional safety monitoring circuitry may take one or more actions, such as disabling the radar system 100, providing a visual notification on a screen of the vehicle 150 indicating that the radar system 100 is not functional or that maintenance is required, or a combination of such actions, as non-limiting examples.

In one or more embodiments, such a failure detection process may further include, while RF signals are being transmitted by the radar system 100, measuring the peak RF voltage along these electrical paths using a peak detector (e.g., the peak detector 404 of FIG. 4). The peak detector may be configured to compare the resulting peak RF voltage measurements to a predetermined peak RF voltage threshold. In response to determining that a given peak RF voltage measurement exceeds the predetermined peak RF voltage threshold, the peak detector may cause a failure indication to be sent (e.g., via flag assertion, binary or non-binary message, or other suitable approaches) to the safety monitoring circuitry of the radar system 100. In one or more embodiments, circuitry separate from the peak detector may monitor the one or more outputs of the peak detector, and may trigger the failure indication to be sent based on the one or more outputs. In response to the failure indication, the functional safety monitoring circuitry may take one or more actions, such as disabling the radar system 100, providing a visual notification on a screen of the vehicle 150 indicating that the radar system 100 is not functional or that maintenance is required, or a combination of such actions, as non-limiting examples.

At block 208, the radar front-end circuitry 102 may be reconfigured or may remain idle until the method 200 returns to block 202 (e.g., at which recalibration of the radar front-end circuitry may be performed).

FIG. 3 shows an illustrative block diagram 300 representing a portion of a transmit module and transmit antenna of a radar system, such as the radar system 100 of FIG. 1, including break detection circuitry 144 configured to monitor interconnection structures (e.g., solder balls, pillars, or the like) in order to determine whether failure of such structures has occurred. The diagram 300 is described here with reference to elements of the radar system 100 of FIG. 1, with like reference numerals used here to denote like elements. However, it should be understood that such reference to the radar system 100 of FIG. 1 is intended to be illustrative and not limiting. For example, other suitable radar systems may implement the circuitry shown of the block diagram 300 in one or more other embodiments.

The diagram 300 shows circuitry disposed as part of an integrated circuit (IC) die, a package, and a circuit board, where the IC die and the circuit board are connected to the package using interconnection structures such as solder balls or electrically conductive pillars. In the present example, the diagram 300 includes an IC die 334, a package 336, and a circuit board 338. The circuit board 338 is physically and electrically attached to the package 336 via a solder ball 324. The package 336 is physically and electrically attached to the IC die 334 via electrically conductive pillars 318 and 320. The conductive pillars 318 and 320 and the solder ball 324 are sometimes referred to herein as "interconnection structures 318, 320, and 324). In accordance with various embodiments, the pillars 318 and 320 may be metal (e.g., copper, as a non-limiting example) structures that may be attached one or both of the IC die 334 and the package 336 using solder.

It should be understood that the arrangement of interconnection structures 318, 320, and 324 is intended to be illustrative and non-limiting. For example, in one or more other embodiments, different arrangements, quantities, or types of interconnection structures may be used to physically connect the IC die 334 and the circuit board 338 to the package 336, and to electrically connect power combiner 125 to the antenna 126-1.

As shown, the IC die 334 includes at least the power amplifiers 124-1 and 124-2, the power combiner 125, and the break detection circuitry 144. It should be understood that, in one or more embodiments, the IC die 334 may additionally include other portions of RF front-end circuitry (e.g., the splitter 123, the RF conditioning circuitry 122, or other suitable RF front-end circuitry, as non-limiting examples).

The power combiner 125 may include a first inductive loop 302 and a second inductive loop 304, which may be electromagnetically (e.g., inductively) coupled to one another. In one or more embodiments, the first inductive loop 302 and the second inductive loop 304 may be formed in separate layers of the IC die 334. The second inductive loop 304 may be connected to outputs of the power amplifier 124-1 and to outputs of the power amplifier 124-2.

The break detection circuitry 144 may include a first output 314 and a second output 316. The first output 314 may be connected to a first portion 306 of the first inductive loop 302 of the power combiner 125. The second output 316 may be connected to a second portion 306 of the first inductive loop 302. The first portion 306 may be connected between the first output 314 and the first conductive pillar 318. The second portion 308 may be connected between the second output 316 and the second conductive pillar 320. The first inductive loop 302 may include breaks separating the first portion 306 from the second portion 308, and such breaks may be located on opposite sides of the first inductive loop 302. For example, a first break 310 may be disposed at the location where the break detection circuitry 144 connects to the first inductive loop 302, and a second break 312 may be disposed at the location where the conductive pillars 318 and 320 connect to the first inductive loop 302. An electrical path 330 may connect the first portion 306 of the first inductive loop 302 through the conductive pillar 318 to a node 322. An electrical path 332 may connect the second portion 308 of the first inductive loop 302 through the conductive pillar 320 to the node 322. The node 322 may be included in the package 336. Signals traveling along the paths 330 and 332 may be combined at the node 322.

The node 322 may be coupled to the antenna 126-1 via the solder ball 324. The antenna 126-1 may be disposed in or on the circuit board 338. A node 326 may be disposed in the circuit board 338 between the solder ball 324 and the antenna 126-1. The node 326 may be connected to a DC ground 328. In one or more embodiments, the DC ground 328 may be implemented as a quarter-wave stub, which may act as an open circuit for RF signals (e.g., RF signals to be transmitted via the antenna 126-1).

Because interconnection structures are potential points of failure in radar systems, it may be desirable to monitor the electrical paths passing through the conductive pillars 318 and 320 and the solder ball 324. In one or more embodiments, such monitoring may include monitoring the voltages at these paths while injecting one or more test currents (e.g., one or more DC test currents) using the break detection circuitry 144 as part of a failure detection process.

For example, the break detection circuitry 144 may be configured to perform a failure detection process by which breakage of any of the interconnection structures (i.e., the pillars 318 and 320 and the solder ball 324) may be detected, in response to which action may be taken by the break detection circuitry to indicate the failure to functional safety circuitry (not shown) of the radar system. In one or more embodiments, one or more steps of such a failure detection process may be performed during a BIST process occurring between transmission of RF signals. That is, such steps of the failure detection process may be performed while the antenna 126-1 is not being used to transmit RF signals. In one or more embodiments, one or more other steps of the failure detection process (e.g., monitoring of the paths 330 and 332 by the peak detector 404 of FIG. 4) may be performed while the antenna 126-1 is being used to transmit RF signals (e.g., during the chirp transmission sequence performed by the radar system 100, as a non-limiting example).

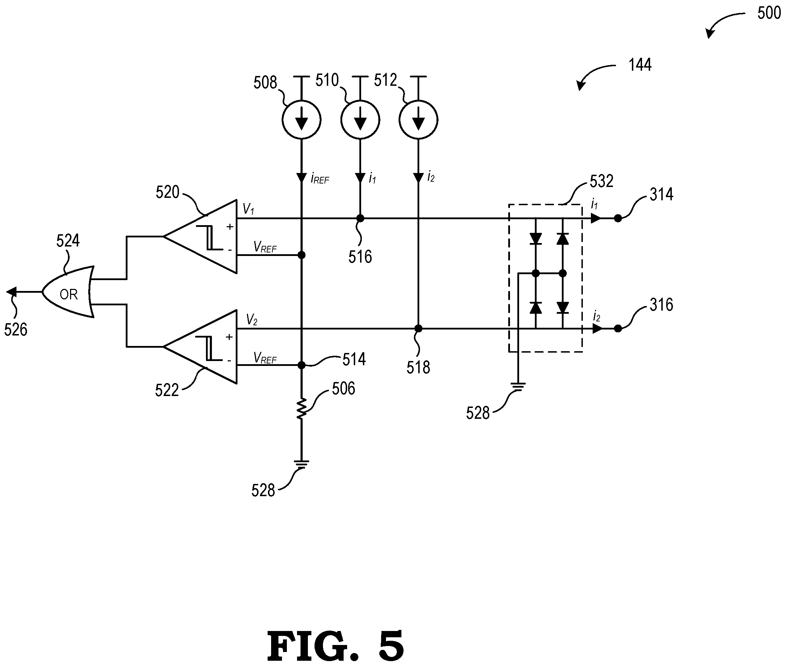

In one or more embodiments, the break detection circuitry 144 may be configured to inject test currents *i₁* and *i₂* into the power combiner 125 while monitoring the voltages at the output nodes 314 and 316 to determine whether any of the conductive pillars 318 or 320 or the solder ball 324 have cracks or breaks disrupting the electrical connection to the antenna 126-1. When the conductive pillars 318 and 320 and the solder ball 324 are undamaged, the injected test current *i₁* passes through the first portion 306 of the first inductive loop 302 and along the path 330 through the conductive pillar 318 to the node 322, and the injected test current *i₂* passes through the second portion 308 of the first inductive loop 302 and along the path 332 through the conductive pillar 320 to the node 322. The test currents *i₁* and *i₂* are combined into a current *i₁+i₂* at the node 322. The combined current *i₁+i₂* is then passed through the solder ball 324 and then to the DC ground 328 via the node 326. The voltages at the outputs 314 and 316 are relatively low when the conductive pillars 318 and 320 and the solder ball 324 are undamaged, but if a break in any of these interconnection structures occurs and interrupts the flow of current to the node 326, the voltage at one or both of the outputs 314 and 316 increases. In response determining that the voltage at either of the outputs 314 and 316 has increased above a reference voltage (e.g., *V_{REF}* in FIG. 5) while the test currents are supplied, the break detection circuitry 144 may be configured to provide a failure indication to, for example, the functional safety monitoring circuitry 148 of the radar system (e.g., the radar system 100). In response to the failure indication, the functional safety monitoring circuitry 148 may take one or more actions, such as disabling the radar system 100, providing a visual notification on a screen of the vehicle 150 indicating that the radar system 100 is not functional or that maintenance is required, or a combination of such actions, as non-limiting examples.

FIG. 4 shows an illustrative block diagram 400 representing a portion of a transmit module and transmit antenna of a radar system, such as the radar system 100 of FIG. 1, including break detection circuitry 144 configured to monitor interconnection structures (e.g., solder balls, pillars, or the like) in order to determine whether failure of such structures has occurred. The diagram 400 is described here with reference to elements of the radar system 100 of FIG. 1, with like reference numerals used here to denote like elements. However, it should be understood that such reference to the radar system 100 of FIG. 1 is intended to be illustrative and not limiting. For example, other suitable radar systems may implement the circuitry shown of the block diagram 400 in one or more other embodiments. One or more aspects of the circuitry illustrated in the diagram 400 may be similar to aspects of the circuitry illustrated in the diagram 300 of FIG. 3, with like reference numerals denoting like elements, and descriptions of such aspects are not necessarily repeated here for sake of brevity.

In one or more embodiments, as shown in the diagram 400, the power combiner 125 may include a first inductive loop 402 that is inductively coupled to the second inductive loop 304 and that includes only a single break 312 disposed at the connection points between the first inductive loop 402 and the paths 330 and 332. In the present example, the outputs 314 and 316 of the break detection circuitry 144 are connected to a single node 406 (e.g., rather than at opposite sides of the break 310 in the example of FIG. 3), such that the injected test currents *i₁* and *i₂* are combined into the combined current *i₁+i₂* prior to injection at the power combiner 125. The combined current is divided at the node 406 and the resultant currents pass along the paths 330 and 332 before being recombined at the node 322 to again form the combined current *i₁+i₂.*

Because the connection between the break detection circuitry 144 and the power combiner 125 does not require an additional break in the first inductive loop 402 in the present example, one or more embodiments of the circuitry of the diagram 400 may have improved RF performance at high frequencies (e.g., above 81 GHz) due to reduced interaction between the break detection circuitry 144 and RF signals passing through the power combiner 125 during RF signal transmission. However, in this arrangement, the break detection circuitry 144 is able to detect a break occurring in both of the conductive pillars 318 and 320, but is not able to detect a break occurring in only one of the conductive pillars 318 and 320.

To address this challenge, a peak detector 404 may be included in the IC die 334, which may be configured and arranged to monitor the peak RF voltage at the paths 330 and 332 while RF signals are provided (e.g., via the paths 330 and 332) to the antenna 126-1 for transmission. In the diagram 400, the peak detector 404 is shown to be connected directly to the paths 330 and 332. However, this arrangement is intended to be illustrative and non-limiting. For example, in one or more other embodiments, the peak detector 404 may be connected to the paths 330 and 332 via one or more couplers (e.g., RF directional couplers).

The peak detector 404 may include circuitry that is configured to obtain peak RF voltage measurements from the paths 330 and 332 while the test currents are injected by the break detection circuitry 144 during the failure detection process. The peak detector 404 may be configured to compare the peak RF voltage measurements to a predetermined threshold. In response to determining that a peak RF voltage measurement at either of the paths 330 and 332 exceeds a predetermined threshold (indicating that one of the conductive pillars 318 and 320 or the solder ball 324 is broken), the peak detector 404 may be configured to provide a failure indication to, for example, the functional safety monitoring circuitry 148 of the radar system, which may take suitable action, as described above, in response to the failure indication. In this way, the peak detector 404 may be capable of detecting a break in a single one of the conductive pillars 318 and 320 as part of a failure detection process.

FIG. 5 shows an illustrative diagram 500 of an example embodiment of the break detection circuitry 144 of FIGS. 1, 3, and 4. As shown, the break detection circuitry may include outputs 314 and 316, current sources 508, 510, and 512, comparators 520, a resistor 506, a logical OR gate 524, and electrostatic discharge (ESD) protection circuitry 532. As shown, the ESD protection circuitry 532 may include a first set of diodes connected between a ground 528 and the output 314 and may further include a second set of diodes connected between the ground 528 and the output 316.

The current source 508 may be coupled to ground 528 via the resistor 506. The current source 508 may supply a current *i_{REF}* through the resistor 506, resulting in a voltage *V_{REF}* at a node 514 that is connected to the current source 508, the resistor 506, and inputs of the comparators 520 and 522. The current source 510 may be coupled to the output 314 via a node 516. The node 516 may be connected to an input of the comparator 520. The current source 510 may supply the first test current *i₁* to the output node 314, resulting in a voltage *V₁* at the node 516. The current source 512 may be coupled to the output 316 via a node 518. The node 518 may be connected to an input of the comparator 522. The current source 512 may supply the second test current *i₂* to the output node 316, resulting in a voltage *V₂* at the node 518.

The comparator 520 receives and compares the voltage *V₁* and the voltage *V_{REF}.* The comparator 520 may be configured to output a "logic high" (e.g., binary 1) signal when *V₁* is greater than *V_{REF},* and may be configured to output a "logic low" (e.g., binary 0) signal when *V₁* is less than *V_{REF}.* A logic high output from the comparator 520 may indicate that one or more interconnection structures coupled to the output 314 are broken, resulting in an open circuit along one or more of corresponding electrical paths.

The comparator 522 receives and compares the voltage *V₂* and the voltage *V_{REF}.* The comparator 522 may be configured to output a "logic high" (e.g., binary 1) signal when *V₂* is greater than *V_{REF},* and may be configured to output a "logic low" (e.g., binary 0) signal when *V₂* is less than *V_{REF}.* A logic high output from the comparator 522 may indicate that one or more interconnection structures coupled to the output 316 are broken, resulting in an open circuit along one or more of corresponding electrical paths.

The OR gate 524 may receive the outputs from the comparators 520 and 522. If either or both of the comparators 520 and 522 output a logic high signal, the OR gate 524 may provide a logic high signal at an output 526. In one or more embodiments, the logic high signal output by the OR gate 524 may cause a failure indication to be sent (e.g., by setting a binary flag or sending a binary or non-binary message) to functional safety monitoring circuitry (e.g., the functional safety monitoring circuitry 148 of FIGS. 1, 3, and 4). In one or more embodiments, the output 526 may be coupled to a register, control circuitry, or functional safety monitoring circuitry, as non-limiting examples, which may receive the signal output by the OR gate 524. The use of the OR gate 524 in the present example is intended to be illustrative and non-limiting. For example, other logic circuitry or controller circuitry may be used to monitor the outputs of the comparators 520 and 522 and to provide failure indications based on the outputs of the comparators 520 and 522 in one or more other embodiments.

FIG. 6 shows an illustrative process flow for a method 600 by which circuitry of a radar system (e.g., the break detection circuitry 144 of FIGS. 1 and 3) may detect and respond to failure (e.g., breaks) in interconnection structures of the radar system. In one or more embodiments, the method 600 may be performed as part of a BIST process (e.g., block 206 of the method 200 of FIG. 2, as a non-limiting example), which may be performed by the radar system once per radar cycle. The method 600 is described here with reference to elements of the radar system 100 of FIG. 1 and the diagram 300 of FIG. 3. However, it should be understood that this is illustrative and not limiting, at least in that other suitable radar systems and circuitry may be used to carry out the method 600 in one or more other embodiments.

At block 602, break detection circuitry of a transmitter module injects test currents onto one or more electrical paths through a power combiner and one or more interconnection structures, the electrical paths leading to a transmit antenna. For example, the break detection circuitry 144 may inject one or more test currents (e.g., test currents *i*₁ and *i*₂) onto the electrical paths 330 and 332 through the power combiner 125. If no interconnection structures are broken, the injected test currents travel through the interconnection structures (e.g., conductive pillars 318, 320 and the solder ball 324) and are routed to ground near the transmit antenna (e.g., routed to the DC ground 328 via the node 326, at or near an input to the antenna 126-1). If at least one interconnection structure is broken, then the voltage at a corresponding electrical path, as seen by the break detection circuitry, increases (e.g., above the voltage level of the reference voltage *V_{REF}*)*.*

At block 604, the break detection circuitry compares voltages at the monitored electrical paths to a reference voltage. In response to determining that either of the monitored electrical path voltages exceeds the reference voltage, the method 600 proceeds to block 606. In response to determining that no electrical path voltages exceed the reference voltage, the method 600 proceeds to block 608. For example, the break detection circuitry 144 may compare the voltage *V₁* at the electrical path 330 to the reference voltage *V_{REF},* and may compare the voltage *V₂* at the electrical path 332 to the reference voltage *V_{REF}* to determine whether *V₁ > V_{REF}* or *V₂ > V_{REF}.*

At block 606, the break detection circuitry indicates failure of the radar system. For example, the break detection circuitry 144 may indicate failure of the radar system 100 in response to determining that *V₁ > V_{REF}* or *V₂ > V_{REF}.* To provide such an indication, the break detection circuitry 144 may assert a binary flag or send a binary or non-binary message to the functional safety monitoring circuitry 148 of the radar system 100, as non-limiting examples. In response to the indication, the functional safety monitoring circuitry 148 may take one or more actions, such as disabling the radar system 100, providing a visual notification on a screen of the vehicle 150 indicating that the radar system 100 is not functional or that maintenance is required, or a combination of such actions, as non-limiting examples.

At block 608, the failure detection process results in no detection of failure, and the radar system continues normal operation. For example, in response to determining that neither *V₁ > V_{REF}* nor *V₂ > V_{REF},* the break detection circuitry 144 may provide no indication of failure, resulting in the continued normal operation of the radar system 100.

FIG. 7 shows an illustrative process flow for a method 700 by which circuitry of a radar system (e.g., the break detection circuitry 144 of FIGS. 1 and 3 and the peak detector 404 of FIG. 4) may detect and respond to failure (e.g., breaks) in interconnection structures of the radar system. In one or more embodiments, the one or more steps of the method 700 (e.g., blocks 702, 704, and 706) may be performed as part of a BIST process (e.g., block 206 of the method 200 of FIG. 2, as a non-limiting example), which may be performed by the radar system once per radar cycle. In one or more embodiments, one or more steps of the method 700 (e.g., blocks 708, 710, and 712) may be performed during transmission of RF signals (e.g., during chirp sequence transmission) by the radar system. The method 700 is described here with reference to elements of the radar system 100 of FIG. 1 and the diagram 400 of FIG. 4. However, it should be understood that this is illustrative and not limiting, at least in that other suitable radar systems and circuitry may be used to carry out the method 700 in one or more other embodiments.

At block 702, break detection circuitry of a transmitter module injects test currents onto one or more electrical paths (e.g., electrical paths leading to a transmit antenna) through a power combiner and one or more interconnection structures while monitoring the voltage(s) at the one or more electrical paths. For example, the break detection circuitry 144 may inject one or more test currents (e.g., test currents *i*₁ and *i*₂) onto the electrical paths 330 and 332 through the power combiner 125 while monitoring the voltages (e.g., voltages *V₁* and *V₂*) at the electrical paths 330 and 332. If no interconnection structures are broken, the injected test currents travel through the interconnection structures (e.g., conductive pillars 318, 320 and the solder ball 324) and are routed to ground near the transmit antenna (e.g., routed to the DC ground 328 via the node 326, at or near an input to the antenna 126-1). If at least one interconnection structure is broken, then the voltage at a corresponding electrical path, as seen by the break detection circuitry, increases (e.g., above the voltage level of the reference voltage *V_{REF}*)*.*

At block 704, the break detection circuitry compares voltages at the monitored electrical paths to a reference voltage. In response to determining that either of the monitored electrical path voltages exceeds the reference voltage, the method 700 proceeds to block 706. In response to determining that no electrical path voltages exceed the reference voltage, the method 700 proceeds to block 708. For example, the break detection circuitry 144 may compare the voltage *V₁* at the electrical path 330 to the reference voltage *V_{REF},* and may compare the voltage *V₂* at the electrical path 332 to the reference voltage *V_{REF}* to determine whether *V₁ > V_{REF}* or *V₂ > V_{REF}.*

At block 706, the break detection circuitry indicates failure of the radar system. For example, the break detection circuitry 144 may indicate failure of the radar system 100 in response to determining that *V₁ > V_{REF}* or *V₂ > V_{REF}.* To provide such an indication, the break detection circuitry 144 may assert a binary flag or send a binary or non-binary message to functional safety monitoring circuitry 148 of the radar system 100, as non-limiting examples. In response to the indication, the functional safety monitoring circuitry 148 may take one or more actions, such as disabling the radar system 100, providing a visual notification on a screen of the vehicle 150 indicating that the radar system 100 is not functional or that maintenance is required, or a combination of such actions, as non-limiting examples.

At block 708, a peak detector measures the peak RF voltage at the monitored electrical paths while RF signals (e.g., radar signals) are provided through the monitored electrical paths for subsequent transmission by the radar system 100. For example, the peak detector 404 may measure the peak RF voltages at the electrical paths 330 and 332 while RF signals are provided along the electrical paths 330 and 332 (e.g., for subsequent transmission via the antenna 126-1).

At block 710, the peak detector compares the measured peak RF voltages to a peak RF voltage threshold. In response to determining that the peak RF voltage measurement at any of the monitored electrical paths exceeds a predetermined peak RF voltage threshold, the method 700 proceeds to block 712. Otherwise, in response to determining that no peak RF voltage measurement exceeds the predetermined peak RF voltage threshold, the method 700 proceeds to block 714. For example, the peak detector 404 may compare the predetermined peak RF voltage threshold to each of the peak RF voltage measurements taken from the electrical paths 330 and 332 to determine whether the peak RF voltage threshold has been exceeded.

At block 712, the failure of the radar system is indicated based on the comparison of the predetermined peak RF voltage threshold and the peak RF voltage measurements. For example, the peak detector (or associated circuitry configured to monitor the outputs of the peak detector) may indicate failure of the radar system 100 in response to determining that any of the peak RF voltage measurements exceeds the predetermined peak RF voltage threshold. To provide such an indication, the peak detector or the associated circuitry may assert a binary flag or send a binary or non-binary message to functional safety monitoring circuitry 148 of the radar system 100, as non-limiting examples. In response to the indication, the functional safety monitoring circuitry 148 may take one or more actions, such as disabling the radar system 100, providing a visual notification on a screen of the vehicle 150 indicating that the radar system 100 is not functional or that maintenance is required, or a combination of such actions, as non-limiting examples.

At block 712, the failure detection process results in no detection of failure, and the radar system continues normal operation. For example, in response to determining that neither *V₁ > V_{REF}* nor *V₂ > V_{REF},* and that the peak RF voltage measurements do not exceed the predetermined peak RF voltage threshold, the break detection circuitry 144 and the peak detector 404 may provide no indication of failure, resulting in continued normal operation of the radar system 100.

While various embodiments of failure detection methods and corresponding circuitry are described herein in the context of radar systems, it should be understood that this is intended to be illustrative and non-limiting. For example, such failure detection methods and circuitry may be used in systems other than radar, such as wireless communication systems.

Various exemplary embodiments are presented below. Some simplifications and omissions may be made in the following examples, which are intended to highlight and introduce some aspects of the various exemplary embodiments, without limiting the scope.

In an example embodiment, a radar system includes a transmit antenna, a transmitter module coupled to the transmit antenna, the transmitter module including a power combiner,

a plurality of interconnection structures coupled between the power combiner and the transmit antenna, and detection circuitry coupled to the power combiner and configured to inject at least one test current onto at least one electrical path that includes the power combiner and at least one of the plurality of interconnection structures, compare a first voltage at the at least one electrical path to a reference voltage, and provide, in response to the first voltage exceeding the reference voltage, a failure indication to safety monitoring circuitry of the radar system.

In one or more embodiments, in response to the failure indication, the safety monitoring circuitry disables the radar system.

In one or more embodiments, the plurality of interconnection structures includes a first interconnection structure that is part of a first electrical path that couples the power combiner to a first node, a second interconnection structure that is part of a second electrical path that couples the power combiner to the first node, and a third interconnection structure that is coupled between the first node and both the transmit antenna and a direct current (DC) ground.

In one or more embodiments, to inject the at least one test current, the detection circuitry is further configured to inject a first test current through a first portion of an inductive loop of the power combiner, and inject a second test current through a second portion of the inductive loop of the power combiner. The first portion of the inductive loop is separate from the second portion of the inductive loop, the first portion of the inductive loop is coupled to the transmit antenna via the first interconnection structure, and the second portion of the inductive loop is coupled to the transmit antenna via the second interconnection structure.

In one or more embodiments, to inject the at least one test current, the detection circuitry is further configured to inject a test current into a second node of a first inductive loop of the power combiner, and the test current is divided at the second node and recombined at the first node.

In one or more embodiments, the transmitter module further includes a peak detector coupled to the first electrical path and the second electrical path, and the peak detector is configured to measure peak voltage values at the first electrical path and the second electrical path while one or more radio-frequency (RF) signals are transmitted by the radar system, and indicate, based on the measured peak voltage values, failure to the safety monitoring circuitry of the radar system.

In one or more embodiments, the first interconnection structure and the second interconnection structure are conductive pillars that connect an integrated circuit die to a package, and the third interconnection structure is a solder ball that connects a circuit board to the package.

In an example embodiment, a method includes performing a failure detection process for a radar system by injecting, by detection circuitry of the radar system, at least one test current onto at least one electrical path including a power combiner and at least one interconnection structure, comparing, by the detection circuitry, a first voltage at the at least one electrical path to a reference voltage, and providing, by the detection circuitry in response to the first voltage exceeding the reference voltage, a failure indication to safety monitoring circuitry of the radar system.

In one or more embodiments, the method further includes disabling the radar system in response to the failure indication.

In one or more embodiments, the at least one electrical path includes a first electrical path that couples the power combiner to a first node and a second electrical path that couples the power combiner to the first node, and the at least one interconnection structure includes a first interconnection structure that is part of the first electrical path, a second interconnection structure that is part of the second electrical path, and a third interconnection structure that is coupled between the first node and both a transmit antenna and a direct current (DC) ground.

In one or more embodiments, injecting the at least one test current includes injecting a first test current through a first portion of an inductive loop of the power combiner, and injecting a second test current through a second portion of the inductive loop of the power combiner. The first portion of the inductive loop is separate from the second portion of the inductive loop, the first portion of the inductive loop is coupled to the transmit antenna via the first interconnection structure, and the second portion of the inductive loop is coupled to the transmit antenna via the second interconnection structure.

In one or more embodiments, injecting the at least one test current includes injecting a test current into a second node of a first inductive loop of the power combiner, and the test current is divided at the second node and recombined at the first node.

In one or more embodiments, the method further includes measuring, by a peak detector, peak voltage values at the first electrical path and the second electrical path during radio-frequency (RF) signal transmission, and indicating, by the peak detector based on the measured peak voltage values, failure to the safety monitoring circuitry of the radar system.

In one or more embodiments, injecting the at least one test current is performed by the detection circuitry while the radar system is not performing radio-frequency (RF) signal transmission.

In an example embodiment, a transmitter module includes a power combiner, interconnection structures coupled to the power combiner, and detection circuitry coupled to the power combiner and configured to inject at least one test current onto at least one electrical path that includes the power combiner and at least one of the interconnection structures, compare a first voltage at the at least one electrical path to a reference voltage, and provide, in response to the first voltage exceeding the reference voltage, a failure indication to safety monitoring circuitry.

In one or more embodiments, providing the failure indication causes a system that includes the transmitter module to be disabled.

In one or more embodiments, the interconnection structures include at least a first interconnection structure that is part of a first electrical path that is connected to the power combiner, and a second interconnection structure that is part of a second electrical path that is connected to the power combiner.

In one or more embodiments, to inject the at least one test current, the detection circuitry is further configured to inject a first test current through a first portion of an inductive loop of the power combiner, and inject a second test current through a second portion of the inductive loop of the power combiner, where the first portion of the inductive loop is separate from the second portion of the inductive loop.

In one or more embodiments, to inject the at least one test current, the detection circuitry is further configured to inject a test current into a node of a first inductive loop of the power combiner. The test current is divided into first and second portions, the first portion of the test current is provided to the first interconnection structure via the first electrical path, and the second portion of the test current is provided to the second interconnection structure via the second electrical path.

In one or more embodiments, the transmitter module further includes a peak detector coupled to the first electrical path and the second electrical path. The peak detector is configured to measure peak voltage values of radio-frequency (RF) signals at the first electrical path and the second electrical path, and indicate, based on the measured peak voltage values, failure to the safety monitoring circuitry of the system.

Although the operations of the method(s) herein are shown and described in a particular order, the order of the operations of each method may be altered so that certain operations may be performed in an inverse order or so that certain operations may be performed, at least in part, concurrently with other operations. In one or more other embodiments, instructions or sub-operations of distinct operations may be implemented in an intermittent and/or alternating manner.

It should also be noted that at least some of the operations for the method(s) described herein may be implemented using software instructions stored on a computer useable storage medium for execution by a computer. As an example, an embodiment of a computer program product includes a computer useable storage medium to store a computer readable program. The computer-useable or computer-readable storage medium can be an electronic, magnetic, optical, electromagnetic, infrared, or semiconductor system (or apparatus or device). Examples of non-transitory computer-useable and computer-readable storage media include a semiconductor or solid-state memory, magnetic tape, a removable computer diskette, a random-access memory (RAM), a read-only memory (ROM), a rigid magnetic disk, and an optical disk.

Alternatively, embodiments herein may be implemented entirely in hardware or in an implementation containing both hardware and software elements. In embodiments which use software, the software may include but is not limited to firmware, resident software, microcode, or other suitable software.

As used herein the terms "circuit" and "circuitry," including the term "processing circuitry" and related terminology means any suitable combination(s) of analog or digital circuit elements, hardware, firmware, software, and the like; including but not limited to, application-specific integrated circuits (ASICs), field programmable gate arrays (FPGAs), microcontrollers, and microprocessors. It will be understood that the term "circuitry" encompasses nonvolatile and volatile memory devices including, but not limited to random access memory (RAM), read-only memory (ROM), and the like, which can be implemented using any suitable devices, such as SRAM, DRAM, or magnetic storage devices as non-limiting examples. Along these lines it will be understood that references to a "processor" or "processing circuitry" can include devices in which general purpose computing devices includes or is otherwise coupled to memory which stores machine-readable instructions configured to cause the processing circuitry to perform the described actions. Such instructions can be stored as instructions in a high level programming language that is readable by human beings which are that are interpreted or compiled into object code or machine language, or they may be stored directly in a low-level language such as object code or machine language or another suitable representation, as nonlimiting examples.

It will be further understood that, unless explicitly stated otherwise, that features such as processing circuitry, memory, and related circuitry and devices can be implemented by any suitable combinations of one or more localized devices including, but not limiting to distributed systems formed by multiple distinct devices in communication with each other via direct electrical communication connections, wireless communication connections, and via public or private communication networks including the Internet. It will further be understood processing circuitry and related devices may be implemented by one or more physical machines or by virtual machines including, but not limited to, virtualized computing environments provided within a "cloud" computing environment or other virtualization systems.

While at least one exemplary embodiment has been presented in the foregoing detailed description, it should be appreciated that a vast number of variations exist. It should also be appreciated that exemplary embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims.

## Claims

1. A radar system comprising:
a transmit antenna; and
a transmitter module coupled to the transmit antenna, the transmitter module comprising:
a power combiner;
a plurality of interconnection structures coupled between the power combiner and the transmit antenna; and
detection circuitry coupled to the power combiner and configured to:
inject at least one test current onto at least one electrical path that includes the power combiner and at least one of the plurality of interconnection structures;
compare a first voltage at the at least one electrical path to a reference voltage; and
provide, in response to the first voltage exceeding the reference voltage, a failure indication to safety monitoring circuitry of the radar system.

2. The radar system of claim 1, wherein, in response to the failure indication, the safety monitoring circuitry disables the radar system.

3. The radar system of claim 1 or 2, wherein the plurality of interconnection structures comprises:
a first interconnection structure that is part of a first electrical path that couples the power combiner to a first node;
a second interconnection structure that is part of a second electrical path that couples the power combiner to the first node; and
a third interconnection structure that is coupled between the first node and both the transmit antenna and a direct current, DC, ground.

4. The radar system of claim 3, wherein, to inject the at least one test current, the detection circuitry is further configured to:
inject a first test current through a first portion of an inductive loop of the power combiner; and
inject a second test current through a second portion of the inductive loop of the power combiner, wherein the first portion of the inductive loop is separate from the second portion of the inductive loop, the first portion of the inductive loop is coupled to the transmit antenna via the first interconnection structure, and the second portion of the inductive loop is coupled to the transmit antenna via the second interconnection structure.

5. The radar system of claim 3 or 4, wherein, to inject the at least one test current, the detection circuitry is further configured to:
inject a test current into a second node of a first inductive loop of the power combiner, wherein the test current is divided at the second node and recombined at the first node.

6. The radar system of claim 5, wherein the transmitter module further comprises:
a peak detector coupled to the first electrical path and the second electrical path, wherein the peak detector is configured to:
measure peak voltage values at the first electrical path and the second electrical path while one or more radio-frequency, RF, signals are transmitted by the radar system; and
indicate, based on the measured peak voltage values, failure to the safety monitoring circuitry of the radar system.

7. The radar system of any of claims 3 to 6, wherein the first interconnection structure and the second interconnection structure are conductive pillars that connect an integrated circuit die to a package, and wherein the third interconnection structure is a solder ball that connects a circuit board to the package.

8. A method comprising:
performing a failure detection process for a radar system by:
injecting, by detection circuitry of the radar system, at least one test current onto at least one electrical path including a power combiner and at least one interconnection structure;
comparing, by the detection circuitry, a first voltage at the at least one electrical path to a reference voltage; and
providing, by the detection circuitry in response to the first voltage exceeding the reference voltage, a failure indication to safety monitoring circuitry of the radar system.

9. The method of claim 8, further comprising:
disabling the radar system in response to the failure indication.

10. The method of claim 8 or 9, wherein the at least one electrical path includes a first electrical path that couples the power combiner to a first node and a second electrical path that couples the power combiner to the first node, and the at least one interconnection structure comprises:
a first interconnection structure that is part of the first electrical path;
a second interconnection structure that is part of the second electrical path; and
a third interconnection structure that is coupled between the first node and both a transmit antenna and a direct current, DC, ground.

11. The method of claim 10, wherein injecting the at least one test current comprises:
injecting a first test current through a first portion of an inductive loop of the power combiner; and
injecting a second test current through a second portion of the inductive loop of the power combiner, wherein the first portion of the inductive loop is separate from the second portion of the inductive loop, the first portion of the inductive loop is coupled to the transmit antenna via the first interconnection structure, and the second portion of the inductive loop is coupled to the transmit antenna via the second interconnection structure.

12. The method of claim 10 or 11, wherein injecting the at least one test current comprises:
injecting a test current into a second node of a first inductive loop of the power combiner, wherein the test current is divided at the second node and recombined at the first node.

13. The method of claim 12, further comprising:
measuring, by a peak detector, peak voltage values at the first electrical path and the second electrical path during radio-frequency (RF) signal transmission; and
indicating, by the peak detector based on the measured peak voltage values, failure to the safety monitoring circuitry of the radar system.

14. The method of any of claims 8 to 13, wherein injecting the at least one test current is performed by the detection circuitry while the radar system is not performing radio-frequency, RF, signal transmission.
